Europäisches Patentamt

European Patent Office

Office européen des brevets

(11) Publication number: **0 388 074**
**A1**

## EUROPEAN PATENT APPLICATION

(21) Application number: **90302446.1**

(22) Date of filing: **07.03.90**

(51) Int. Cl.⁵: **H03K 19/0185, H03K 19/0948**

(30) Priority: **16.03.89 US 324681**

(43) Date of publication of application:
**19.09.90 Bulletin 90/38**

(84) Designated Contracting States:
**DE FR GB IT**

(71) Applicant: **SGS-THOMSON
MICROELECTRONICS, INC.
1310 Electronics Drive
Carrollton Texas 75006(US)**

(72) Inventor: **Guritz, Elmer H.
106 Pecan
Terrell, Texas 75160(US)**
Inventor: **Chan, Tsiu Chiu
1633 Camero Drive
Carrollton, Texas 75006(US)**

(74) Representative: **Palmer, Roger et al
PAGE, WHITE & FARRER 54 Doughty Street
London WC1N 2LS(GB)**

(54) **Cmos level shifting circuit.**

(57) A voltage level shifting circuit is used on CMOS integrated circuits. Cross-coupled devices use positive feedback on the gates of 2 P-channel transistors (42,44) to drive one completely off. True and inverted input signals (A,B, $\overline{A}$, $\overline{B}$) are applied to N-channel transistors (54,56,62,64) connected to the 2 P-channel transistors (42,44), and true and complementary outputs (OUTA, $\overline{OUTA}$) are available. N-channel transistors can be combined to perform a logic function in addition to the voltage level function.

*Fig.3.*

EP 0 388 074 A1

# CMOS LEVEL SHIFTING CIRCUIT

The present invention relates generally to integrated circuits, and more specifically to voltage level shifting and logic functions in CMOS devices.

As integrated circuits are fabricated using smaller device sizes, the use of lower on-chip operating voltages is often necessary. These lower voltages are necessitated in part due to hot electron effects which occur when very thin gate oxides are used, and metal electromigration problems which can occur with very small signal traces.

For many applications, the electronics industry has standarized around the use of 5 volt TTL logic signals for communication between chips. Because of the problems which occur at smaller geometries, semiconductor manufacturers use lower voltages for on-chip operation for many devices. 3.3 volts is a typical on-chip operating voltage, and lower voltages can be expected as device geometries continue to shrink.

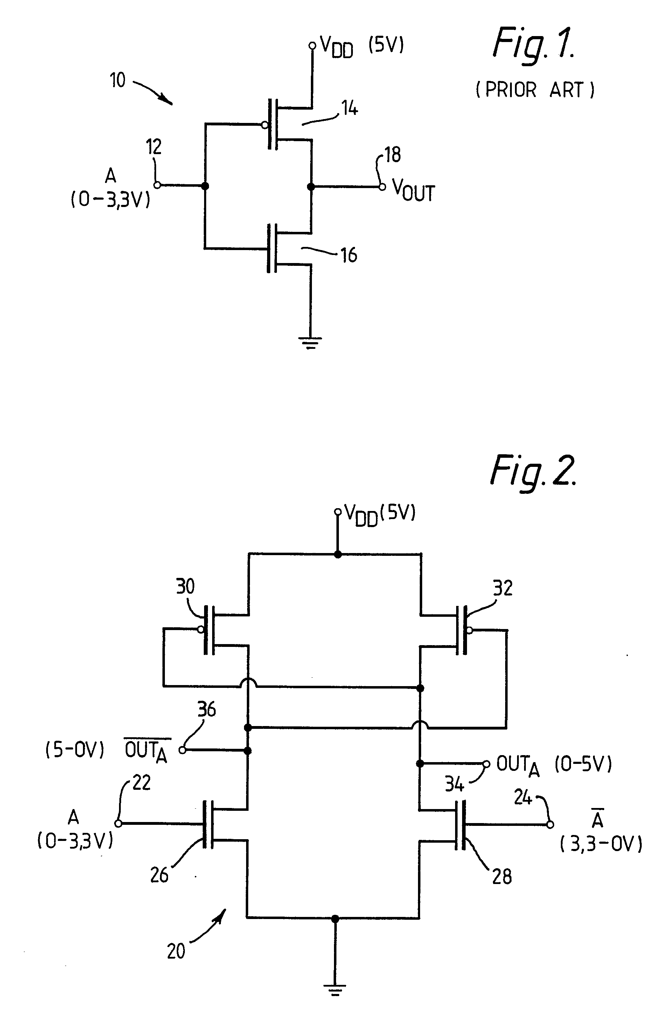

A voltage level converter is needed to translate 3.3 volt on-chip levels to the 5 volt levels needed for off-chip signals. Figure 1 illustrates a prior art circuit typically used for this purposes.

In Figure 1, an inverter 10 has an input node 12 connected to the gates of a P-channel transistor 14 and an N-channel transistor 16. Output node 18 has the inverted signal of the input signal A

The input on node 12 varies from 0 to 3.3 volts. The supply voltage for the inverter 10 is 5 volts, so the signal on node 18 ideally varies from 0 to 5 volts. When the input signal is 0 volts, transistor 16 is off and transistor 14 is on. This gives an output of 5 volts at node 18. When the input signal is 3.3 volts, transistor 16 is on but P-channel transistor 14 is not turned completely off. This happens because the 5 volt drain voltage is significantly higher than the 3.3 volt gate voltage, which allows leakage current to flow. Although the voltage on node 18 is 0 volts, as required, the leakage current through the inverter in this condition can be as high as 10 to 100 microamps for each inverter 10.

In a CMOS circuit with 20 voltage level shifters on 20 output lines, several milliamps of DC current drain occurs during steady state conditions. Since CMOS circuits are designed for use in low power systems, this current drain can be significant and undesirable. For example, some CMOS circuits are designed with built-in battery backups in order to retain their state if system power is lost. With a drain of several milliamps for a single chip, it is possible for these limited capacity backup batteries to be discharged before system power is returned.

With some devices, voltage level shifters are needed for signals coming onto an integrated circuit chip, even when 5 volt TTL signals are used between chips. Because of the design of TTL circuits, voltage levels typically switch between 0 and approximately 2.5 volts. This 2.5 volt signal must be boosted to a 3.3 volt signal for on-chip use. The same leakage problem described in connection with **Figure 1** can occur on input buffers also, with the P-channel transistor not quite turning off.

Other circuits on a chip can also occasionally benefit from using a higher voltage supply. For example, sense amps and other drivers having a high fan-out on the chip can sometimes take advantage of a higher supply voltage in order to improve performance. All of these subcircuits must be driven by an inverter such as shown in **Figure 1**, or an equivalent circuit, and all will tend to have DC leakage through the P-channel transistor when the input signal to the inverter is zero volts. The more voltage level conversions which must be done on a chip, the greater the DC leakage problem.

It would therefore be desirable for a CMOS voltage level shifting circuit to function without a DC leakage current due to incomplete turnoff of the P-channel transistor.

It is therefore an object of the present invention to provide a CMOS level shifting circuit which has virtually no leakage current.

It is a further object of the present invention to provide such a level shifting circuit which can also operate as a function generator.

It is also of the present invention to provide a function generator which provides complementary output functions with or without voltage level shifting.

Therefore, according to the present invention, a voltage level shifting circuit has cross-coupled CMOS circuits with complementary inputs. The P-channel transistors are driven completely off using positive feedback, virtually eliminating leakage currents. N-channel transistors can be connected so as to perform various logic functions.

The novel features believed characteristic of the invention are set forth in the appended The invention itself however, as well as a preferred mode of use, and further objects and advantages thereof, will best be understood by reference to the following detailed description of an illustrative embodiment when read m conjunction with the accompanying drawings, wherein:

Figure 1 is an illustration of a prior art voltage level shifting CMOS inverter circuit;

Figure 2 is a schematic diagram of a voltage level shifting circuit according to the present invention; and

Figure 3 is a schematic diagram of a voltage level shifting circuit according to the present invention which includes output function generation.

As described in the background, **Figure 1** shows a prior art inverter used for voltage level shifting in CMOS circuits. Such prior art circuits have a significant DC current leakage when the input voltage at node **12** is 3.3 volts for the reasons described above.

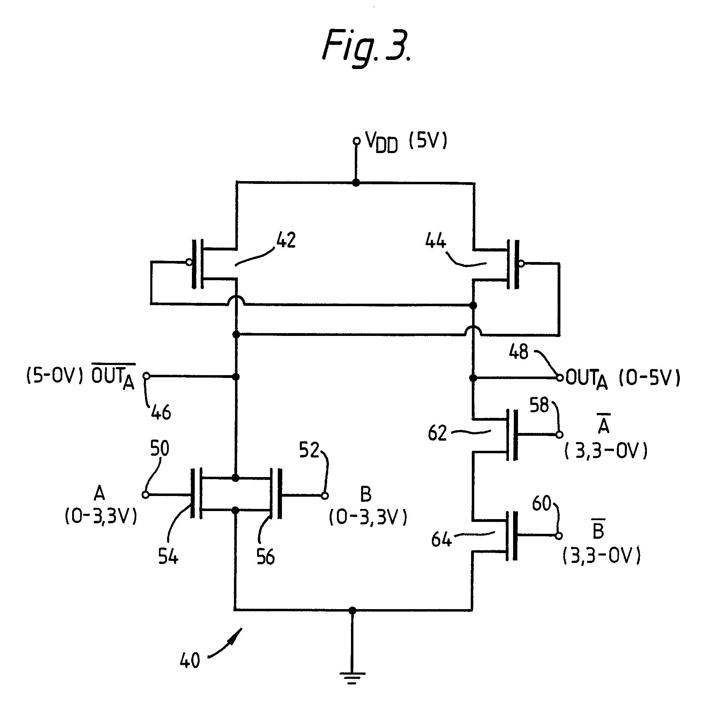

Referring to **Figure 2**, a voltage level shifting circuit which does not suffer from significant DC current leakage due to an incompletely turned-off P-channel transistor is shown. The circuit **20** has complementary inputs **22** and **24** connected to N-channel transistors **26** and **28** respectively. P-channel transistors **30**, **32** are connected to N-channel transistors **26**, **28** respectively, and to a 5 volt supply $V_{DD}$.

Node **34** is the node between transistors **28** and **32**, and is an output signal having the same logic state as the input signal at node **22**. Node **36** is the connection between transistors **26** and **30**, and is an output signal having the same logic state as the input signal at node **24**. The gate of transistor **30** is connected to node **34**, and the gate of transistor **32** is connected to node **36**.

As will be appreciated by those skilled in the art, the circuit **20** acts in a manner similar to a latch, with positive feedback to the gates of transistors **30** and **32**. When the input A is low, the input $\overline{A}$ is high. Under these conditions, transistor **26** will be turned off, with transistor **28** turned on. This brings the voltage at node **34** to ground potential, turning transistor **30** on. With transistor **30** on and transistor **26** off, the voltage at node **36** is equal to $V_{DD}$, which is shown as 5 volts in **Figure 2**. This voltage at node **36** turns transistor **32** off. Since a 5 volt signal is being used to turn off transistor **32**, instead of a 3.3 volt signal such as was the case in **Figure 1**, transistor **32** turns completely off.

Thus, when the input at node **22** is low and the input at node **24** is high, transistors **26** and **32** are turned completely off. Thus, there is no undesired leakage current due to an incompletely turned off P-channel transistor.

When the input at node **22** is high, and the input at node **24** is low, the circuit **20** operates in an analogous manner. Under these conditions, transistor **30** will be turned off by a 5 volt signal and transistor **28** will be turned off by a 0 volt signal. Thus, the voltage at node **34** will be 5 volts, and the voltage at node **36** will be 0 volts.

Referring to **Figure 3**, an alternative embodiment which can operate as a function generator as well as a voltage shifter is shown as circuit **40**. The upper part of circuit **40** operates in the same manner as that of circuit **20**. P-channel transistors **42** and **44** correspond to transistors **30** and **32** respectively. Output nodes **46** and **48** correspond to output nodes **36** and **34** respectively.

Input nodes **50** and **52** are connected to the gates of N-channel transistors **54** and **56** respectively. Input nodes **58** and **60** are connected to the gates of N-channel transistors **62** and **64** respectively. The logical value of the signal at node **58** is the complement of the signal at node **50**, and the signal at node **60** is the complement of that at node **52**.

The circuit **40** operates in a manner analogous to that of circuit **20**. If either of the signals A or B are high (3.3 volts), the corresponding transistor **54** or **56** will be on, bringing the voltage at node **46** to 0. The complementary signal on node **58** or **60** will be low, causing the corresponding transistor **62** or **64** to be off, causing the voltage at node **48** to go to 5 volts when the P-channel transistor **44** is turned-on by the 0 volt signal at node **46**. The 5 volt signal at node **48** drives the P-channel transistor **42** off.

It will be appreciated by those skilled in the art that the voltage at node **46** is equal to the logical combination $\overline{A} \cdot \overline{B}$, while that at node **48** is equal to A + B. With input voltages having a maximum level of 3.3 volts, 5 volt output voltages are obtained with no excess leakage through the P-channel transistors **42** or **44**.

Circuit **40** can be used to generate a function and its complement even without the level shifting feature shown in **Figure 3**. This would occur when the input voltages range from 0 to $V_{DD}$. Such a function generator circuit requires true and complement signals for all inputs, and generates an output function and its complement, either or both of which may be used as desired. When circuit **40** is used as a voltage level shifting circuit, the last logic stage before the acquired level shift can be incorporated as shown in **Figure 3**, and very few or no extra transistor elements are required to perform the level shifting function.

As shown in **Figure 3**, standard N-channel logic design techniques can be used to generate functions of any desired complexity. It is only necessary that the functions performed by the left and right side of the circuit **40** be truly complementary. If this were not the case, one or more possible input states will turn on both P-channel transistors **42** and **44**, and create a large current flow to ground.

As is known in the art, fabrication of P-channel transistors is more difficult than fabrication of N-channel transistors, and the resulting P-channel transistors require more surface area on the integrated circuit. Therefore, a circuit such as shown in **Figure 3** which combines a logic function with the use of only two P-channel transistors results in a functional block which is easily fabricated and takes up a minimum amount of area on an integrated circuit chip.

As described above, the level shifting circuitry of **Figures 2** and **3** can be used to drive off-chip output stages, or can be used whenever higher voltage circuitry is needed on a chip. Since both a function and its complement are available as outputs from circuits **20** and **40**, metallization can be used to define the function actually applied to an output pin of an integrated circuit chip. This will allow the fabrication of a single basic chip design to be used for different output pin function definitions depending on the layout of the metallization mask.

While the invention has been particularly shown and described with reference to a preferred embodiment, it will be understood by those skilled in the art that various changes in form and detail may be made therein without departing from the spirit and scope of the invention.

**Claims**

1. A voltage level shifting circuit, comprising:
a first field effect transistor having a channel of a first conductivity type connected to a voltage source and a first output signal node;
a second field effect transistor having a channel of the first conductivity type connected to the voltage source and a second output signal node;
a third field effect transistor having a channel of a second conductivity type connected to the first output signal node and a reference potential; and
a fourth field effect transistor having a channel at a second conductivity type connected to the second output signal node and the reference potential;
wherein a gate of said first transistor is connected to the second output signal node, and a gate of said second transistor is connected to the first output signal node.

2. The circuit of Claim 1, wherein the first conductivity type is P-type, and the second conductivity type is N-type.

3. The circuit of Claim 1, wherein the voltage source is 5 volts, and input signals coupled to gates of said third and fourth transistors are less than approximately 3.3 volts.

4. The circuit of Claim 1, wherein the voltage source is approximately 3.3 volts, and input signals coupled to gates of said third and fourth transistors are less than approximately 3.3 volts.

5. A CMOS function circuit, comprising:
a first field effect transistor having a channel of a first conductivity type connected to a voltage source and a first output signal node;
a second field effect transistor having a channel of the first conductivity type connected to the voltage source and a second output signal node;
a first set of field effect transistors having channels of a second conductivity type, said first set defining a logic function connected to the first output signal node and for a reference potential; and
a second set of field effect transistors having channels of a second conductivity type, said second set defining a logic function complementary to the first set logic function, and connected to the second output signal node and to the reference potential;
wherein a gate of said first transistor is connected to the second output signal node, and a gate of said second transistor is connected to the first output signal node.

6. The circuit of Claim 1, wherein the first conductivity type is P-type, and the second conductivity type is N-type.

7. The circuit of Claim 5, wherein set first set and said second set each contain at least two transistors.

8. A voltage level shifting circuit, comprising:
a first field effect transistor having a channel of a first conductivity type connected to a voltage source and a first output signal node;
a second field effect transistor having a channel of the first conductivity type connected to the voltage source and a second output signal node;
a first set of field effect transistors having channels of a second conductivity type, said first set defining a logic function connected to the first output signal node and for a reference potential; and
a second set of field effect transistors having channels of a second conductivity type, said second set defining a logic function complementary to the first set logic function, and connected to the second output signal node and to the reference potential;
wherein a gate of the first transistor is connected to the second output signal node and a gate of the second transistor is connected to the first output signal node;
and further wherein the voltage source provides a first voltage, and input signals coupled to gates of transistors in said first and second sets have a maximum voltage which is different from the first voltage.

9. The circuit of Claim 8, wherein the input signals have a maximum voltage which is less than the first voltage.

10. The circuit of Claim 9, wherein the first voltage is 5 volts, and the input signals have a maximum voltage of approximately 3.3 volts.

11. The circuit of Claim 9, wherein the first voltage is approximately 3.3 volts, and the input signals have a maximum voltage less than approximately 3.3 volts.

12. The circuit of Claim 8, wherein the first conductivity type is P-type and the second conductivity type is N-type.

13. The circuit of Claim 8, wherein said first set and said second set each contain at least two transistors.

*Fig.1.*

( PRIOR ART )

*Fig.2.*

# Fig.3.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | RESEARCH DISCLOSURE no. 284, December 1987, page 782, New York, US; "Low Swing Complementary Metal Oxide Silicon off Chip Receiver" * whole document * | 1,2 | H 03 K 19/0185 H 03 K 19/0948 |
| A | idem | 3-6,8,9 ,12 | |
| X | PATENT ABSTRACTS OF JAPAN vol. 8, no. 243 (E-277)(1680), 8 November 1984; & JP - A - 59 122 222 (SONY K.K.) 14.07.1984 | 1,2 | |
| X | PATENT ABSTRACTS OF JAPAN vol. 9, no. 150 (E-324)(1873), 25 June 1985; & JP - A - 60 30213 (MITSUBISHI DENKI K.K.) 15.02.1985 | 1,2 | |
| X | PATENT ABSTRACTS OF JAPAN vol. 6, no. 182 (E-131)(1060), 18 September 1982; & JP - A - 57 95726 (TOKYO SHIBAURA DENKI K.K.) 14.06.1982 | 1,2 | TECHNICAL FIELDS SEARCHED (Int. Cl.5) |
| X | PATENT ABSTRACTS OF JAPAN vol. 4, no. 10 (E-167), 25 January 1980; & JP - A - 54 150 955 (MITSUBISHI DENKI K.K.) 27.11.1979 | 1,2 | H 03 K 19/0185 H 03 K 19/0948 |
| P,X | PATENT ABSTRACTS OF JAPAN vol. 13, no. 350 (E-800)(3698), 7 August 1989; & JP - A - 109824 (NEC CORPORATION) 26.04.1989 | 1,2 | |
| X | US-A-4 314 166 (O.H. BISMARCK) * figure 1; column 2, line 17 - column 3, line 24 * -/- | 1,2 | |

The present search report has been drawn up for all claims

| Place of search | Date of completion of the search | Examiner |
|---|---|---|
| BERLIN | 29-05-1990 | ARENDT M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)

European Patent
Office

**EUROPEAN SEARCH REPORT**

Application Number

EP  90 30 2446

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 916 430  (R.C. HEUNER et al.) * figure 1 * | 1,2 | |
| P,X | DE-A-3 729 925  (SIEMENS AG) * figure 1; abstract * | 1,2 | |
| X | DD-A- 249 363 (VEB ZENTRUM WISSENSCHAFT UND TECHNIK) * figure 1; abstract * | 1,2 | |
| X | IBM TECHNICAL DISCLOSURE BULLETIN vol. 27, no. 1b, June 1984, pages 657,658, New York, US; W.J. CRAIG et al.: "CVS Logic Circuit with decoupled outputs" * whole document * | 5-7 | |
| X | IEEE JOURNAL OF SOLID-STATE CIRCUITS vol. SC-21, no. 6, December 1986, pages 1082-1087, Vancouver, CANADA; K.M. CHU et al.: "Design Procedures for Differential Cascode Voltage Switch Circuits" * section II; figures 1,2 * | 5-7 | TECHNICAL FIELDS SEARCHED (Int. Cl.5) |
| X. | PATENT ABSTRACTS OF JAPAN vol. 9, no. 131 (E-319)(1854), 6 June 1985; & JP - A - 60 18018 (SUWA SEIKOSHA K.K.) 30.01.1985 | 5-7 | |

The present search report has been drawn up for all claims

| Place of search | Date of completion of the search | Examiner |
|---|---|---|
| BERLIN | 29-05-1990 | ARENDT M |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
......................................................................................................
& : member of the same patent family, corresponding
   document

EPO FORM 1503 03.82 (P0401)